(19) Europäisches Patentamt
European Patent Office
Office européen des brevets

(11) **EP 2 667 449 A1**

(12) **EUROPEAN PATENT APPLICATION**

(43) Date of publication:
**27.11.2013 Bulletin 2013/48**

(51) Int Cl.:
*H01Q 9/40* (2006.01)  *H01Q 19/10* (2006.01)
*H01Q 5/00* (2006.01)

(21) Application number: **12169025.9**

(22) Date of filing: **23.05.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **NXP B.V.**
**5656 AG Eindhoven (NL)**

(72) Inventors:
• **Spella, Maristella**
**5656 AG Eindhoven (NL)**

• **De Graauw, Antonius Johannes Matheus**
**5656 AG Eindhoven (NL)**

(74) Representative: **Williamson, Paul Lewis**
**NXP Semiconductors**
**Intellectual Property and Licensing**
**Red Central**
**60 High Street**
**Redhill, Surrey RH1 1SH (GB)**

(54) **Integrated circuit package having an integrated antenna**

(57)    An antenna design is based on a ball grid array ball or set of balls. This enables integration of an active die and a monopole antenna in a standard BGA (ball grid array) package.

FIG. 3

EP 2 667 449 A1

## Description

This invention relates to antenna designs, which can be integrated with the transceiver associated with the antenna in a single package. The invention is of particular interest for mm and shorter wavelength systems (i.e. frequencies of tens of GHz and above).

The packaging of integrated circuits for mm-wave communication, radar and imaging systems has long been dominated by the use of expensive specialised technologies such as low loss ceramics and thin-film processes. In addition, such packages are mounted on specialised mm-wave substrates on which the antenna is integrated.

An important motivation for using dedicated packaging technology and substrates is the need for a well-defined interconnection between the transceiver and the antenna that offers low loss and low parasitic effects at mm-wave frequencies.

Now that these mm-wave applications are entering mass consumer markets, there is a strong drive for low cost alternatives for the package and board. A major cost reduction can be achieved by integrating the antenna in the package, which relaxes the requirements on the board significantly since the mm-wave interconnect is limited by the antenna connection in the package. The known concepts do however still need special expensive packages in order to integrate the antenna function.

One of the most popular antenna types that is often used in wireless communication, radar and imaging equipment is the micro-strip antenna which is a mechanically simple, robust and inexpensive structure that can be used as a single element radiator but can also be used to construct linear and planar conformal antenna arrays. Unfortunately the performance of this type of antenna is strongly dependent on the permittivity and thickness of the substrate.

For example, the impedance bandwidth of resonant antennas is a function of the thickness and the dielectric constant of the antenna dielectric.

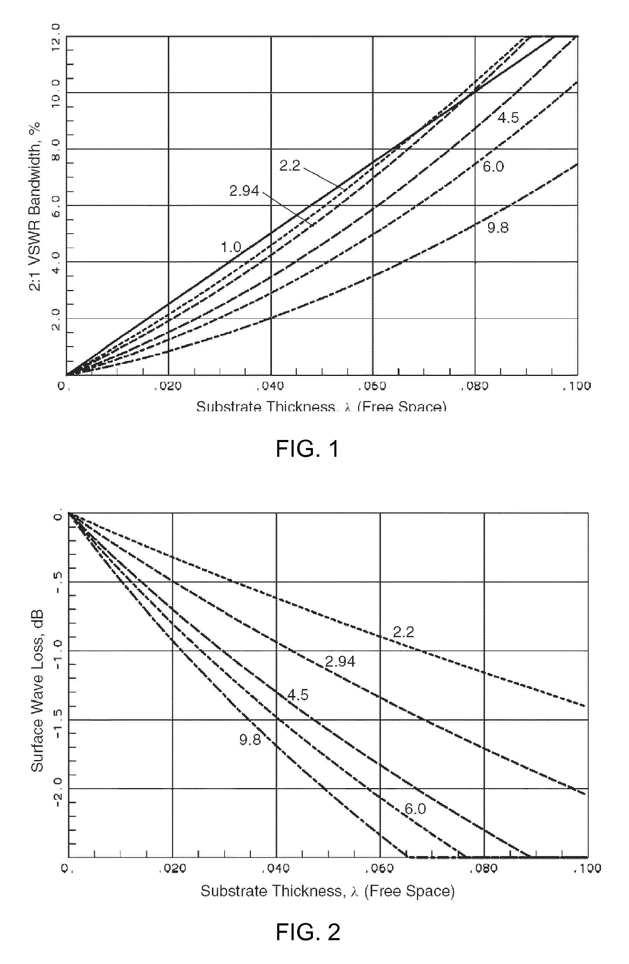

Figure 1 shows the impedance bandwidth of a standard square shaped patch antenna as function of the substrate thickness and dielectric constant including surface wave losses.

The substrate thickness on the x-axis is shown as a function of the signal wavelength (from 0 to 0.1 times the wavelength). The different plots show different dielectric constant (from 1.0 to 9.8). The y-axis shows the 2:1 VSWR bandwidth in %.

Figure 1 shows that the impedance bandwidth increases with the substrate thickness and decreases with the dielectric permittivity. The VSWR value of 2:1 means that the reflection coefficient is 0.33 or -9.5dB. Figure 1 shows the bandwidth as a percentage for which the antenna input impedance is less than - 9.5 dB. Basically, the VSWR bandwidth is the frequency range as a percentage of the tuned frequency of the antenna, over which the VSWR is at most 2:1.

The Gain G of an antenna is defined by the product of efficiency $\eta$ and directivity D:

$$G= \eta.D$$

The directivity is mainly defined by the spatial distribution and orientation of the radiators and ground-plane(s) and not relevant in this context. The efficiency of micro-strip antennas is defined by the dielectric and conductive material losses but also by the power lost in the surface wave that can be launched in the substrate. The energy in this wave is generally considered as lost energy since it does not contribute to the radiation in the desired direction.

Figure 2 shows the surface wave efficiency of a standard square shaped patch antenna as function of the substrate thickness and dielectric constant.

Again, the substrate thickness on the x-axis is shown as a function of the signal wavelength (from 0 to 0.1 times the wavelength). The different plots show different dielectric constant (from 2.2 to 9.8). The y-axis shows the surface wave loss in dB.

The results of Figures 1 and 2 show a clear trade-off between impedance bandwidth, which increases with substrate thickness, and surface wave efficiency which decreases with substrate thickness.

There are various different approaches for realising micro-strip antennas that are optimized with respect to impedance bandwidth and efficiency.

A first approach is to use a special low dielectric constant and low loss microwave laminate as a dielectric between a patch antenna and a ground plane. Examples of the dielectrics with low dielectric constant and loss are PTFE, Foam, and the Rogers RT/Duroid (Trade Mark) high frequency laminates.

A second approach is to provide a layer structure which creates an air-gap within a laminate structure between the antenna and the ground-plane. The air dielectric ensures optimum performance regarding impedance bandwidth and surface wave efficiency.

A third approach is to use a bond-wire as an antenna. A metal plate below the bond-wire forms the ground plane of the antenna. This approach is attractive because it does not require any special dielectric since the antenna can be formed as simply a half loop in air. This design also has a more omnidirectional radiation pattern compared to micro-strip antennas. The main drawback of this solution is the difficulty to have a well-controlled shape and length for the wire-bonds.

The known methods for realising a System in a Package (SiP) with integrated micro-strip Antenna (array) have a number of well-known disadvantages.

A general disadvantage of the known concepts is that the transceiver and antenna use different substrates as a result of the different requirements for the antenna and transceiver. The substrate requirements for the transceiver include aspects like high density flip-chip interconnect and low thermal resistance. Those for the antenna relate to the dielectric thickness, dielectric constant and material losses. The disadvantage of using different substrates in a SiP is that the resulting interconnect structure is generally quite complex which results in efficiency and bandwidth loss due to parasitic effects.

The main drawback of the approach that uses special mm-wave substrate materials with low dielectric constant and low loss is that such materials are incompatible with the mainstream large volume mass production processes. Teflon based materials like RT/Duroid (Trade Mark) (Er=2.9, tan $\delta$ =0.0012) and Ultralam2000 (Trade Mark) (Er=2.5, tan $\delta$ =0.0022) and also Foam (Er=1.1, tan $\delta$ < 0.001) are substantially more expensive due to the low production volumes and  the requirement to accurately control and guarantee the dielectric properties up to high frequencies. In addition, the mechanical and thermal properties of these materials deviate significantly from the standard laminate materials like epoxy which makes them less suitable for standard assembly methods like (fine pitch) flip-chip and ball grid array packaging. The performance of this approach is still limited to the dielectric constant which is still significantly higher than that of an air dielectric (Er=1, tan $\delta$ =0) for most of these materials.

The main disadvantage of the use of a special assembly construction to create an air-gap between the antenna and the ground-plane is the fact that such special assembly methods are generally not compatible with mainstream large volume mass production processes. Special assembly methods are substantially more expensive than the production of mainstream packages due to the lower production volumes. In addition, the mechanical and thermal properties of such special constructions deviate significantly from the standard packaging methods which make them less suitable for standard assembly methods like (fine pitch) flip-chip and ball grid array packaging.

According to the invention, there is provided an integrated circuit package as claimed in claim 1.

The invention provides an integrated circuit package comprising an integrated circuit and an antenna electrically coupled to the integrated circuit, wherein the radiating element of the antenna comprises (only) a set of one or more solder balls.

This antenna design enables a low cost integrated package to be formed, for example for mm-wave systems (and sub-mm wave systems) such as THz communications, radar and imaging systems.

The invention can be implemented using a standard ball or balls of a BGA (ball grid array) package, to form an antenna or antenna array.

The package preferably comprises a printed circuit board, and the integrated circuit is mounted on the printed circuit board. The printed circuit board can be of conventional design and does not require the use of special materials.

The integrated circuit can be mounted on one side of the circuit board and the set of solder balls of the antenna is provided on the opposite side of the printed circuit board. A respective via then extends from the or each solder ball through the printed circuit board for connection to the integrated circuit.

The printed circuit board can comprise a multi-layer circuit board having an internal ground plane. A pair of connections is then made to the ground plane in the vicinity of the or each solder ball, symmetrically disposed around the solder ball.

The solder balls can be formed by standard BGA processing. For example they can have a diameter in the range 0.5 to 2mm.

The radiating element of the antenna can comprise a single solder ball or else there may be a set of a plurality of solder balls. A set of solder balls can be used to form a phased array antenna.

The set of solder balls can for example comprise two solder balls spaced by a distance equal to half of an intended transmission or reception wavelength of the antenna.

The package can be used in a mm-wave or a sub-mm wave transceiver.

Examples of the invention will now be described in detail with reference to the accompanying drawings, in which:

Figure 1 shows the impedance bandwidth of a standard square shaped patch antenna;
Figure 2 shows the surface wave efficiency of a standard square shaped patch antenna;
Figure 3 shows an example of an antenna of the invention packaged with an active die (i.e. an integrated circuit);
Figure 4 shows a cross-section and a 3D view of an example of a single antenna;
Figure 5 shows the impedance bandwidth with respect to frequency of the antenna for a source impedance of 39 Ohms for the antenna of Figure 4;
Figure 6 shows a representation of the total electric field and the directivity of the antenna of Figure 4;
Figure 7 shows how a larger ground plane can be used;
Figure 8 shows a representation of the total electric field and the directivity for the antenna of Figure 7;
Figure 9 shows an example of a phased array antenna formed using two BGA balls;
Figure 10 shows a representation of the total electric field when there is no phase difference between the driving signals and the directivity for the antenna of Figure 9; and
Figure 11 shows a representation of the total electric field when a phase of 180 degrees difference between the driving signals is applied and the directivity for the antenna of Figure 9.

The invention provides an antenna design which enables integration of an active die and a monopole antenna in a standard BGA (ball grid array) package.

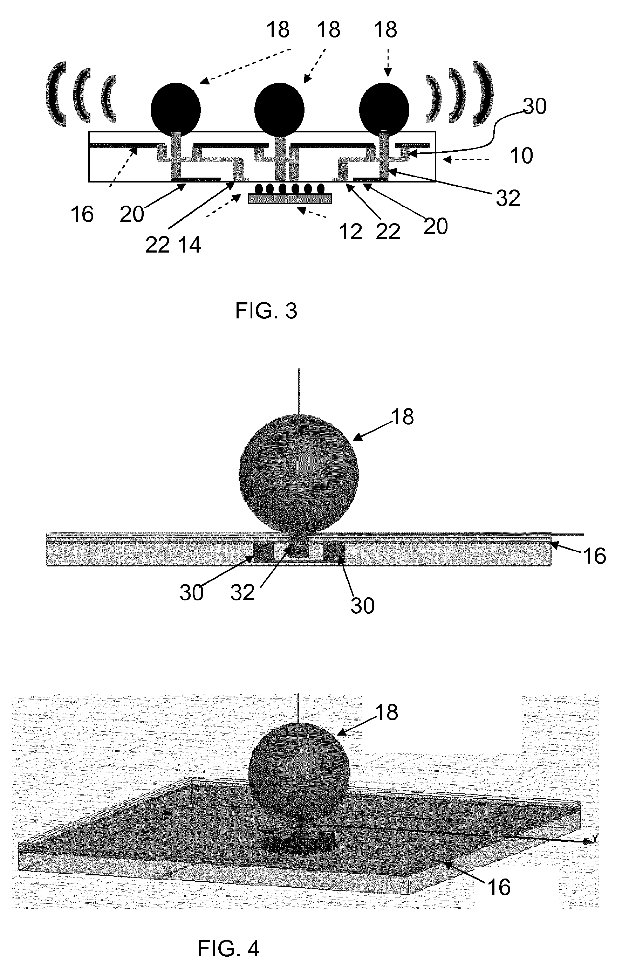

Figure 3 shows an example of an antenna of the invention packaged with an active die (i.e. an integrated circuit).

The package comprises a PCB substrate 10 having an integrated circuit 12 mounted on one side, for example by flip chip bonding (shown as 14). The integrated circuit typically includes a transceiver circuit which is associated with the antenna.

A ground plane 16 is embedded near the opposite side of the PCB substrate.

The antenna is defined as a set of standard BGA balls 18 forming an antenna array.

Each BGA ball 18 connects to a signal line of the integrated circuit by means of vias through the PCB and interconnects 20 formed on the circuit side of the PCB. These vias extend through openings in the ground plane 16. The ground plane connects to external terminals 22.

The use of BGA balls in this way has a number of advantages compared to prior art:

- The antenna array is mainly surrounded by air thus it is very efficient and it has also a more omnidirectional radiation pattern compared to micro-strip antennas.
- The approach is suitable for use with standard materials. This relaxes the requirements on the dielectric constant and dielectric loss of the package material.
- The approach is suitable for use in a standard BGA assembly process.

The height of the antenna is determined by the ball height which is a well-controlled parameter in high volume assembly processes.

A first example of application of the packaging approach of the invention is the integration of a transceiver chip with an antenna for mm-wave communication, radar or imaging applications. For the purposes of explanation, an antenna in the form of a single BGA solder ball will be discussed.

Figure 4 shows a cross-section and a 3D view of an example of the single antenna ball.

The antenna can use a standard BT (epoxy resin) laminate with Er=3.5 and tan δ=0.02 to support the antenna elements.

The BGA ball 18 is a solder ball with a diameter of 1.2mm.

To feed the antenna it is preferable to have two symmetric vias 30 connected to ground and one via 32 connected to the signal line.

In Figure 4, the whole rectangular area is the ground and there is a hole to allow the connection to the signal via 32. The vias 30 are needed to have a return path for the current. The ground plane is connected to an external ground by the connections 22 shown in Figure 3.

With this construction the antenna (the solder ball) is mainly surrounded by air, and this makes the antenna very efficient. In fact with a dielectric permittivity of 1 the surface wave losses are 0 and the impedance bandwidth can be broad. Moreover the ground plane on the PCB has very limited effect on the antenna performance.

The performance of the antenna has been analysed by performing a number of electro-magnetic simulations.

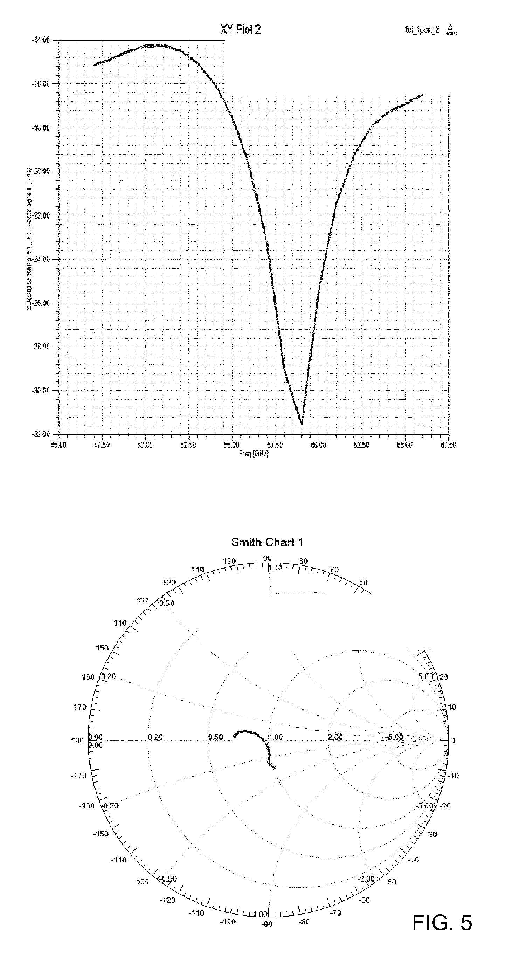

Figure 5 shows the impedance bandwidth with respect to frequency of the antenna for a source impedance of 39 Ohms.

The top plot shows the input reflection coefficient (S11) plotted against frequency and the bottom plot shows the Smith chart for the same frequency sweep.

In the frequency range between 47GHz and 67GHz the antenna shows very wide impedance bandwidth.

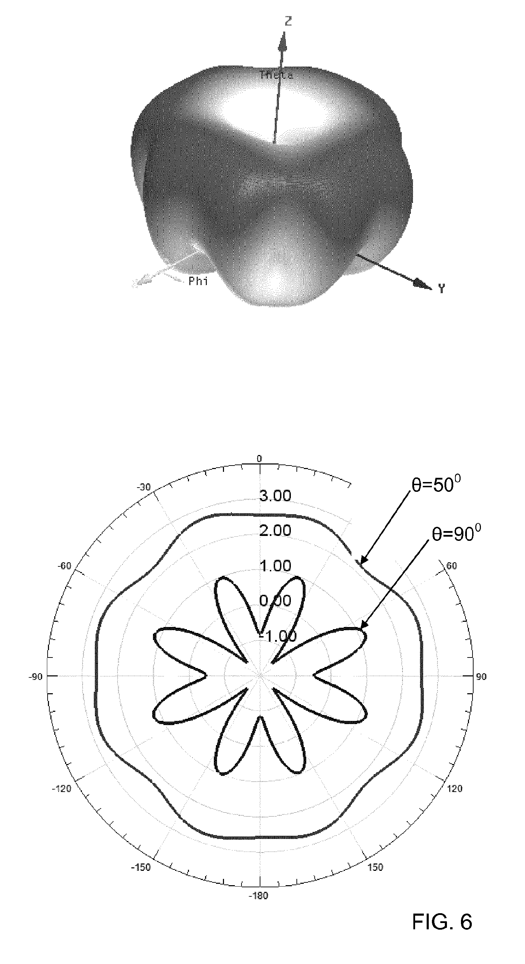

Figure 6 shows in the top image a representation of the total electric field. The bottom plot shows the directivity for theta equal to 50deg and 90deg of the BGA antenna. The value of theta is the angle to the z axis (perpendicular to the PCB), with the antenna in the x-y plane.

For theta equal to -50deg, the antenna directivity is around 2.5 dBi in the full azimuth plane. This is a very important feature since it is possible to cover a larger area compared to a more directive antenna.

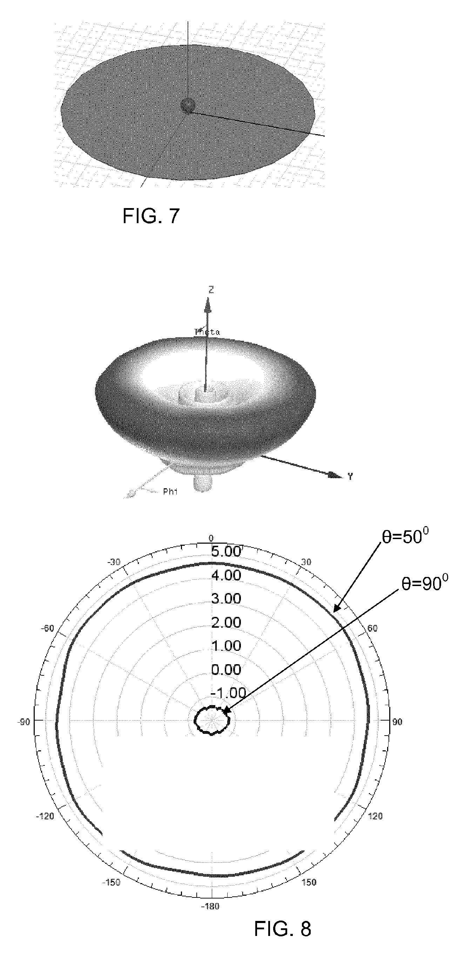

By using a larger ground with a circular shape as shown in Figure 7 it is possible to achieve a more omnidirectional radiation pattern in the azimuth plane and a higher directivity with a smaller beam width. Figure 7 shows a BGA antenna on a 20mm diameter circular ground.

Figure 8 shows in the top image a representation of the total electric field. The bottom plot shows the directivity again for theta equal to -50deg and -90deg of the BGA antenna.

The examples above use a single BGA ball as the antenna.

Multiple BGA balls can be used to achieve a higher gain antenna (without beam steering).

Another implementation of the invention can use a phased array antenna to achieve beam steering. In this way, a transceiver chip can be integrated with a phased array antenna for mm-wave communication, radar or imaging applications.

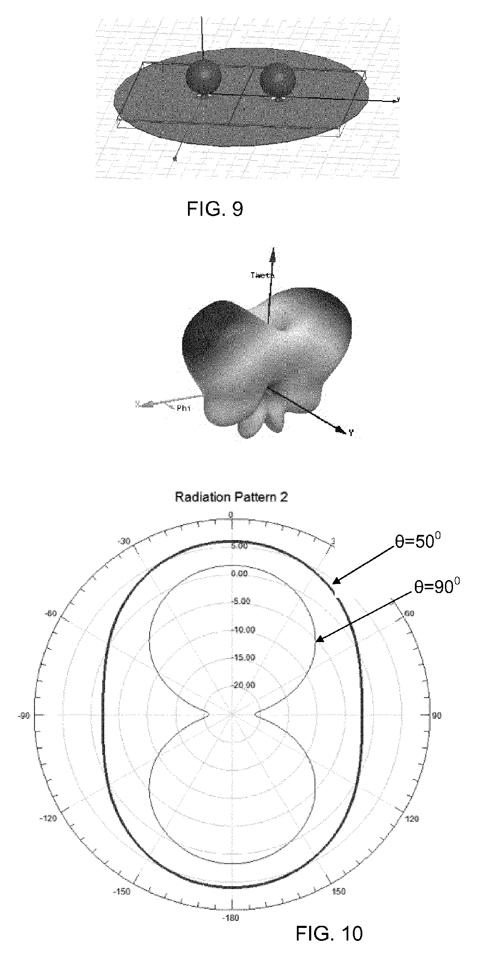

Figure 9 shows an example of a phased array antenna formed using two BGA balls to implement a linear phased array antenna with λ/2 element spacing.

Figure 10 shows in the top image a representation of the total electric field when there is no phase difference between the driving signals. The bottom plot shows the directivity for theta equal to -50deg and -90deg of the BGA antenna.

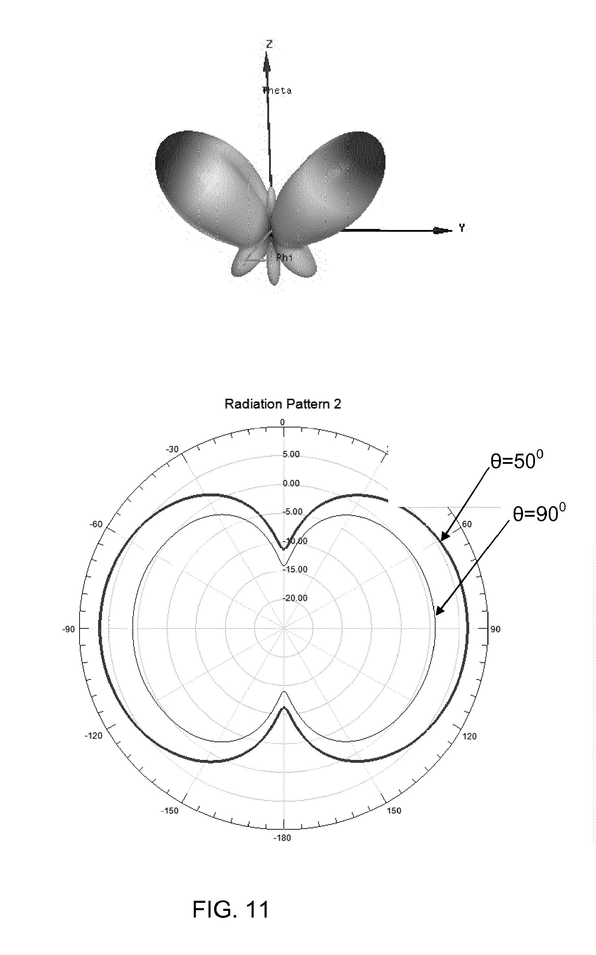

Figure 11 shows in the top image a representation of the total electric field when a phase of 180 degrees difference between the driving signals is applied. The bottom plot again shows the directivity for theta equal to -50deg and -90deg of the BGA antenna.

Thus, by applying a phase difference of 180 degrees between the two elements it is possible to scan the beam direction from phi (the angle to the x-axis) equal to 0 degrees as shown in Figure 10 to phi equal to 90 degrees as shown in Figure 11.

The same concept can be applied for a larger number of BGA elements.

The invention enables integrated circuits to be combined with single antennas as well as to array antennas.

A first example of particular use of the system of the invention is in 60GHz wireless systems for distribution of high quality streaming video signals or for the transfer of ultra high bit-rate data streams.

A second example is the use in 77GHz car radar systems for adaptive cruise control.

A third example is the use of the concept above 100GHz for imaging based security systems.

It will be clear from the description above that the ball or balls of the BGA are used as the radiating elements of the antenna, rather than being used to couple a circuit to another antenna structure. Thus, the radiating element comprises only the solder ball or balls. The solder ball or balls of the antenna are connected to the circuit board at their base, but are exposed to free space around the remainder of their surface area, i.e. not connected to other components.

Standard BGA solder compositions can be used for the solder balls.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. Any reference signs in the claims should not be construed as limiting the scope.

## Claims

1. An integrated circuit package comprising an integrated circuit (12) and an antenna electrically coupled to the integrated circuit, wherein the radiating element of the antenna comprises a set of one or more solder balls (18).

2. A package as claimed in claim 1, comprising a printed circuit board (10) wherein the integrated circuit (12) is mounted on the printed circuit board.

3. A package as claimed in claim 2, wherein the integrated circuit (12) is mounted on one side of the circuit board and the set of solder balls (18) of the antenna is provided on the opposite side of the printed circuit board.

4. A package as claimed in claim 3, comprising a respective via (32) extending from the or each solder ball (18) through the printed circuit board (10) for connection to the integrated circuit (12).

5. A package as claimed in claim 2, 3 or 4, wherein the printed circuit board (10) comprises multi-layer circuit board having an internal ground plane (16).

6. A package as claimed in claim 5, wherein a pair of connections (30) is made to the ground plane in the vicinity of the or each solder ball (18), symmetrically disposed around the solder ball.

7. A package as claimed in any preceding claim, wherein each solder ball (18) has a diameter in the range 0.5 to 2mm.

8. A package as claimed in any preceding claim, wherein the radiating element of the antenna comprises a single solder ball (18).

9. A package as claimed in any one of claims 1 to 7, wherein the radiating element of the antenna comprises a set of a plurality of solder balls (18).

10. A package as claimed in claim 9, wherein the set of solder balls (18) form a phased array antenna.

11. A package as claimed in claim 10, wherein the set of solder balls comprises two solder balls (18) spaced by a distance equal to half of an intended transmission or reception wavelength of the antenna.

12. A mm-wave or sub-mm-wave transceiver comprising a package as claimed in any preceding claim, wherein the integrated circuit (12) comprises a transceiver circuit.

FIG. 1

FIG. 2

6

FIG. 3

FIG. 4

XY Plot 2

1el_1port_2

FIG. 5

Smith Chart 1

FIG. 6

FIG. 7

FIG. 8

FIG. 9

Radiation Pattern 2

$\theta=50^0$

$\theta=90^0$

FIG. 10

Radiation Pattern 2

$\theta=50^0$

$\theta=90^0$

FIG. 11

**Europäisches Patentamt**

**European Patent Office**

**Office européen des brevets**

## EUROPEAN SEARCH REPORT

Application Number

EP 12 16 9025

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2002/145566 A1 (BALLANTINE ARNE W [US] ET AL) 10 October 2002 (2002-10-10)<br>* abstract *<br>* paragraphs [0004] - [0013], [0019] - [0027]; figure 2 *<br>----- | 1-12 | INV.<br>H01Q9/40<br>H01Q19/10<br>H01Q5/00 |
| X | US 2008/238792 A1 (HEINRICH WOLFGANG [DE] ET AL) 2 October 2008 (2008-10-02)<br>* abstract *<br>* paragraphs [0002] - [0029]; figure 2 *<br>----- | 1-12 | |
| X | US 2002/171591 A1 (BEARD PAUL [US])<br>21 November 2002 (2002-11-21)<br>* paragraphs [0003] - [0011], [0035] - [0052]; figure 1 *<br>----- | 1-12 | |
| A | US 6 770 955 B1 (COCCIOLI ROBERTO [US] ET AL) 3 August 2004 (2004-08-03)<br>* column 4, line 8 - column 8, line 25 *<br>----- | 1-12 | |
| | | | TECHNICAL FIELDS SEARCHED (IPC)<br><br>H01Q |

The present search report has been drawn up for all claims

| Place of search | Date of completion of the search | Examiner |
|---|---|---|
| The Hague | 16 November 2012 | Sidoti, Filippo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 12 16 9025

This annex lists the patent family members relating to the patent documents cited in the above-mentioned European search report.
The members are as contained in the European Patent Office EDP file on
The European Patent Office is in no way liable for these particulars which are merely given for the purpose of information.

16-11-2012

| Patent document cited in search report | | | Publication date | Patent family member(s) | | | Publication date |
|---|---|---|---|---|---|---|---|
| US 2002145566 | A1 | | 10-10-2002 | NONE | | | |
| US 2008238792 | A1 | | 02-10-2008 | AT | 366465 | T | 15-07-2007 |
| | | | | DE | 102004014018 | B3 | 11-08-2005 |
| | | | | EP | 1726063 | A1 | 29-11-2006 |
| | | | | JP | 2007529930 | A | 25-10-2007 |
| | | | | US | 2008238792 | A1 | 02-10-2008 |
| | | | | WO | 2005091438 | A1 | 29-09-2005 |
| US 2002171591 | A1 | | 21-11-2002 | EP | 1413004 | A1 | 28-04-2004 |
| | | | | JP | 4121860 | B2 | 23-07-2008 |
| | | | | JP | 2004533166 | A | 28-10-2004 |
| | | | | JP | 2008219897 | A | 18-09-2008 |
| | | | | US | 2002171591 | A1 | 21-11-2002 |
| | | | | WO | 02093685 | A1 | 21-11-2002 |
| US 6770955 | B1 | | 03-08-2004 | NONE | | | |